# EUROPEAN PATENT APPLICATION

(11) **EP 4 482 261 A1**
(43) Date of publication of application: **25.12.2024**
(21) Application number: 23770335.0
(22) Date of filing: 24.02.2023
(51) Int. Cl.: H05K 1/09, H05K 1/03

(54) **CERAMIC COMPOSITE SUBSTRATE, AND PRODUCTION METHOD FOR CERAMIC COMPOSITE SUBSTRATE**

(30) Priority: 16.03.2022 JP 2022041686
(71) Applicant: Denka Company Limited, Tokyo 103-8338 (JP)
(72) Inventor: TSUGAWA, Yuta, Tokyo 103-8338 (JP); YANO, Seiji, Tokyo 103-8338 (JP); TANAKA, Junichi, Tokyo 103-8338 (JP)
(74) Representative: Hoffmann Eitle
(86) International application number: PCT/JP2023/006811
(87) International publication number: WO 2023/176376

(57) **Abstract**

A ceramic composite substrate according to one aspect of the present disclosure includes: a ceramic plate; a first circuit unit provided on a main surface of the ceramic plate; and a second circuit unit provided on the main surface in a state of being spaced apart from the first circuit unit along a predetermined direction. The first circuit unit includes a bonding body provided on the main surface, a metal body bonded to the main surface with the bonding body interposed therebetween, and a metal coating formed so as to cover a surface of the metal body and a portion of the bonding body protruding from the metal body. The bonding body includes a silver bonding layer bonded to the metal body and having a silver content of 50 mass% or more. The metal coating includes a lateral portion formed so as to cover a lateral surface of the silver bonding layer, the lateral surface facing the second circuit unit. A distance L in the predetermined direction between an end portion of the lateral portion close to the second circuit unit and an end portion of the silver bonding layer close to the second circuit unit is larger than a thickness H of the metal coating.

## Description

### Technical Field

The present disclosure relates to a ceramic composite substrate and a production method for a ceramic composite substrate.

### Background Art

Patent Literature 1 discloses a ceramic metal circuit board including a ceramic substrate, and a first metal plate and a second metal plate bonded to a first surface and a second surface, respectively, of the ceramic substrate with respective bonding layers interposed therebetween. In this circuit board, a metal coating is provided on a surface of the first metal plate opposite to the bonding surface with the ceramic substrate, and a portion where a metal coating is not provided is present on a part of a surface of the second metal plate opposite to the bonding surface with the ceramic substrate with the aim of mounting a semiconductor element or a metal terminal.

### Citation List

### Patent Literature

Patent Literature 1: Japanese Patent No. 6797797

### Summary of Invention

### Technical Problem

The present disclosure provides a ceramic composite substrate capable of improving insulation properties between circuit units, and a production method for a ceramic composite substrate.

### Solution to Problem

A ceramic composite substrate according to one aspect of the present disclosure includes: a ceramic plate; a first circuit unit provided on a main surface of the ceramic plate; and a second circuit unit provided on the main surface in a state of being spaced apart from the first circuit unit along a predetermined direction. The first circuit unit includes a bonding body provided on the main surface; a metal body bonded to the main surface with the bonding body interposed therebetween; and a metal coating formed so as to cover a surface of the metal body and a portion of the bonding body protruding from the metal body. The bonding body includes a silver bonding layer bonded to the metal body and having a silver content of 50 mass% or more. The metal coating includes a lateral portion formed so as to cover a lateral surface of the silver bonding layer, the lateral surface facing the second circuit unit. A distance L in the predetermined direction between an end portion of the lateral portion close to the second circuit unit and an end portion of the silver bonding layer close to the second circuit unit is larger than a thickness H of the metal coating.

The distance L may be more than 2 µm. The thickness H may be 2 µm or more.

The ceramic plate may contain silicon nitride or aluminum nitride. The metal coating may contain nickel or gold.

A production method for a ceramic composite substrate according to one aspect of the present disclosure includes: a step of etching a part of a metal body and a part of a bonding body so as to form a first circuit unit and a second circuit unit in a state of being spaced apart from each other along a predetermined direction in an intermediate, in the intermediate the metal body being bonded to a main surface of a ceramic plate with the bonding body interposed therebetween, the bonding body including a silver bonding layer bonded to the metal body and having a silver content of 50 mass% or more; and a step of forming a metal coating so as to cover a surface of a part of the metal body constituting the first circuit unit and form a lateral portion covering a lateral surface of a part of the silver bonding layer constituting the first circuit unit, the lateral surface facing the second circuit unit, after the step of etching. A distance L in the predetermined direction between an end portion close to the second circuit unit of the lateral portion included in the metal coating and an end portion close to the second circuit unit of a part of the silver bonding layer constituting the first circuit unit is larger than a thickness H of the metal coating.

### Advantageous Effects of Invention

According to the present disclosure, there are provided a ceramic composite substrate capable of improving insulation properties between circuit units, and a production method for a ceramic composite substrate.

### Brief Description of Drawings

FIG. 1 is a plan view schematically illustrating an example of a ceramic composite substrate.
FIG. 2 is an end view taken along line II-II illustrated in FIG. 1.
FIG. 3(a) and FIG. 3(b) are examples of SEM images of an observation cross section.
FIG. 4(a), FIG. 4(b), FIG. 4(c), and FIG. 4(d) are schematic views for describing an example of a production process.
FIG. 5(a), FIG. 5(b), and FIG. 5(c) are schematic views for describing an example of a production process.

### Description of Embodiments

Hereinafter, embodiments will be described with reference to the drawings. The following embodiments are examples for describing the present disclosure, and are not intended to limit the present disclosure to the following contents. In the description, the same elements or elements having the same function are denoted by the same reference numerals, and redundant description will be omitted. The dimensional ratio of each element is not limited to the illustrated ratio. Some of the drawings show an orthogonal coordinate system defined by an X-axis, a Y-axis, and a Z-axis.

### [Ceramic Composite Substrate]

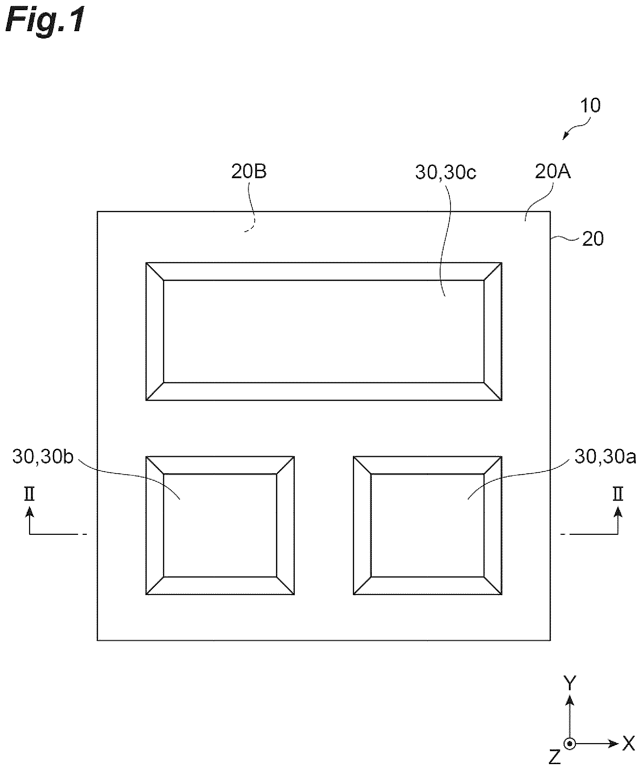

FIG. 1 schematically illustrates an example of a ceramic composite substrate according to an embodiment. A ceramic composite substrate 10 illustrated in FIG. 1 is, for example, a substrate (circuit board) used as a component of a power module and the like. The ceramic composite substrate 10 includes a ceramic plate 20 and a metal circuit board 30.

The ceramic plate 20 is formed in a flat plate shape. The ceramic plate 20 includes a pair of main surfaces opposite to each other. Hereinafter, one of the pair of main surfaces is referred to as a "front surface 20A", and the other is referred to as a "back surface 20B". The shape of the outer edge of the front surface 20A may have a quadrangular shape. In the present disclosure, of the outer edge of the front surface 20A, a direction in which one set of sides parallel to each other extend is referred to as an "X-axis direction", and a direction in which another set of sides parallel to each other extend is referred to as a "Y-axis direction". A thickness direction (direction orthogonal to the front surface 20A) of the ceramic plate 20 is referred to as a "Z-axis direction". For convenience of description, in the Z-axis direction, a direction from the back surface 20B toward the front surface 20Ais referred to as "upper", and a direction from the front surface 20A toward the back surface 20B is referred to as "lower".

A material (ceramic) for forming the ceramic plate 20 is not particularly limited. The ceramic plate 20 is, for example, a silicon nitride plate or an aluminum nitride plate. A thickness of the ceramic plate 20 may be 0.1 mm to 1 mm, 0.1 mm to 0.6 mm, or 0.2 mm to 0.4 mm.

The metal circuit board 30 is a portion constituting a circuit included in the ceramic composite substrate 10. A chip (electronic component) may be mounted on the metal circuit board 30. The metal circuit board 30 is provided on the front surface 20A of the ceramic plate 20. The metal circuit board 30includes, for example, a circuit unit 30a, a circuit unit 30b, and a circuit unit 30c. The circuit unit 30a, the circuit unit 30b, and the circuit unit 30c are disposed on the front surface 20A in a state of being separated from each other. For example, when the circuit unit 30a configures a first circuit unit, the circuit unit 30b configures a second circuit unit. When three or more circuit units are provided, a set of circuit units having the smallest distance between the circuit units may be selected as the first circuit unit and the second circuit unit among a plurality of sets of circuit units adjacent to each other.

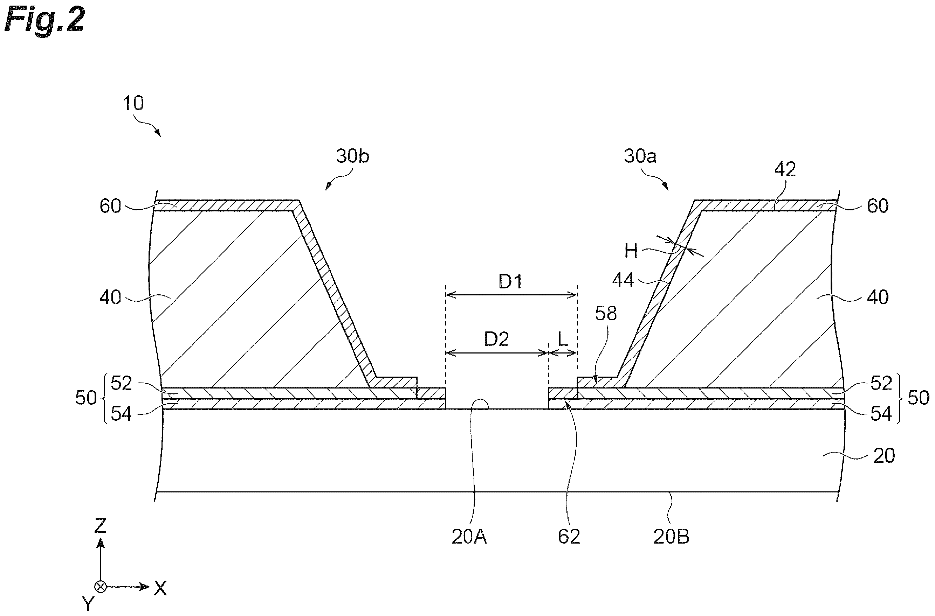

The circuit unit 30a, the circuit unit 30b, and the circuit unit 30c are disposed inside the outer edge of the front surface 20A. In the example illustrated in FIG. 1, the circuit unit 30a and the circuit unit 30b are arranged in the X-axis direction (predetermined direction). In this case, the circuit unit 30b is provided on the front surface 20A in a state of being spaced apart from the circuit unit 30a along the X-axis direction. In the Y-axis direction, the circuit unit 30a and the circuit unit 30c are arranged side by side, and the circuit unit 30b and the circuit unit 30c are arranged side by side. The circuit unit 30a, the circuit unit 30b, and the circuit unit 30c may be configured so as to be similar to each other. Hereinafter, an example of one circuit unit will be described using the circuit unit 30a. FIG. 2 schematically illustrates a cross section of the ceramic composite substrate 10 along the line II-II in FIG. 1 on an X-Z plane. As illustrated in FIG. 2, the circuit unit 30a includes a metal body 40, a bonding body 50, and a metal coating 60.

The metal body 40 has conductivity. The metal body 40 is, for example, a copper plate. The metal body 40 may be configured by one of a copper alloy, aluminum, and an aluminum alloy, instead of copper. The metal body 40 includes an upper surface 42 and a lateral surface 44. The upper surface 42 may be parallel (substantially parallel) to the front surface 20A. The lateral surface 44 extends from the outer edge of the upper surface 42 toward the front surface 20A. The lateral surface 44 may be inclined with respect to a direction (Z-axis direction) orthogonal to the front surface 20A. The lateral surface 44 may be inclined away from the end portion of the upper surface 42 as it approaches the front surface 20A. In this case, the area of the cross section of the metal body 40 along an X-Y plane increases as it approaches the front surface 20A. A thickness of the metal body 40 (a distance in the Z-axis direction between the lower surface and the upper surface 42 of the metal body 40) may be 0.1 mm to 2 mm, 0.15 mm to 1.5 mm, or 0.2 mm to 1 mm. When the metal body 40 (at least a part of the metal body 40) is formed to extend in one direction, a length in an extending direction of the metal body 40 may be 5 mm to 100 mm, and a width of the metal body 40 may be 1 mm to 70 mm.

The bonding body 50 is provided on the front surface 20A, and bonds the metal body 40 to the ceramic plate 20 (front surface 20A). That is, the metal body 40 is bonded to the front surface 20A with the bonding body 50 interposed therebetween. The bonding body 50 is provided between the metal body 40 and the front surface 20A, at least a part of the upper surface of the bonding body 50 is in contact with (bonded to) the metal body 40, and at least a part of the lower surface of the bonding body 50 is in contact with (bonded to) the front surface 20A.

A region near the outer edge of the bonding body 50 protrudes from the outer edge of the metal body 40. The region near the outer edge of the bonding body 50 protrudes outward from between the metal body 40 and the front surface 20A, for example, in the entire periphery thereof. In the present disclosure, in the case of focusing on one circuit unit, the terms "inside" and "outside" are used with reference to the center of the circuit unit. When the front surface 20A is viewed from the Z-axis direction, the outer edge of the bonding body 50 may surround the outer edge of the metal body 40. Hereinafter, a portion of the bonding body 50 protruding outward from between the metal body 40 and the front surface 20A is referred to as an "extending portion".

The bonding body 50 may be configured by an Ag-Cu-Sn-based brazing material. The Ag-Cu-Sn-based brazing material contains silver, copper, tin, and an active metal. A silver content in the bonding body 50 may be 50 mass% or more. The silver content in the bonding body 50 may be 60 mass% or more, 70 mass% or more, or 80 mass% or more. The silver content in the bonding body 50 may be 98 mass% or less. The copper content in the bonding body 50 may be 5 parts by mass to 20 parts by mass with respect to 100 parts by mass of silver. A tin content in the bonding body 50 may be 0.5 parts by mass to 15 parts by mass, 0.5 parts by mass to 5 parts by mass, or 1 part by mass to 5 parts by mass, with respect to 100 parts by mass of the total of silver and copper.

The active metal includes at least one selected from the group consisting of titanium, zirconium, hafnium, and niobium. A content of the active metal in the bonding body 50 may be 0.5 parts by mass to 10 parts by mass, 0.5 parts by mass to 5 parts by mass, or 2 parts by mass to 5 parts by mass, with respect to 100 parts by mass of the total of silver and copper. The active metal may be contained as a hydride, and may include, for example, titanium hydride (TiH₂). The content of TiH₂ in the bonding body 50 may be 0.5 parts by mass to 10 parts by mass, 1 part by mass to 5 parts by mass, or 2 parts by mass to 5 parts by mass, with respect to 100 parts by mass of the total of silver and copper. When the active metal includes a plurality of metals, the content of the active metal is the total content of the plurality of metals.

The bonding body 50 includes a first bonding layer 52 and a second bonding layer 54. The first bonding layer 52 is a layer having a silver content of 50 mass% or more. In the phase of forming the bonding body 50 (at the time of heating for bonding the metal body 40), a silver component among materials constituting the bonding body reacts with a metal component (for example, copper) contained in the metal body 40 to form a layer containing silver as a main component on the upper side. In the present disclosure, the fact that silver is contained as a main component means that the silver content is 50 mass% or more. The first bonding layer 52 (silver bonding layer) is bonded to the metal body 40.

The second bonding layer 54 is a layer having a silver content smaller than that of the first bonding layer 52. The second bonding layer 54 is a portion other than the first bonding layer 52 in the bonding body 50. The silver content in the second bonding layer 54 is less than 50 mass%. The second bonding layer 54 is bonded to the front surface 20A of the ceramic plate 20. As described above, the first bonding layer 52 is bonded to the metal body 40 and the second bonding layer 54 is bonded to the front surface 20A, whereby the metal body 40 is bonded to the front surface 20A with the bonding body 50 including the first bonding layer 52 and the second bonding layer 54 interposed therebetween. When the ceramic plate 20 contains a nitride and the active metal constituting the bonding body 50 contains titanium, the second bonding layer 54 may contain nitrogen and titanium. In the second bonding layer 54, the total content of nitrogen and titanium may be larger than the content of the other components (the content of each component). The silver content in the second bonding layer 54 may be 30 mass% or less. A thickness of the second bonding layer 54 may be 500 nm or less, or may be 100 nm to 500 nm.

The first bonding layer 52 is overlaid on the second bonding layer 54. A part of the first bonding layer 52 may be discontinuously formed, and a part of the second bonding layer 54 may be discontinuously formed. The fact that the first bonding layer 52 is overlaid on the second bonding layer 54 means that the first bonding layer 52 covers the second bonding layer 54 in most (for example, a portion of 70% or more) of the bonding body 50 when viewed from the Z-axis direction. Here, a cross section of the ceramic composite substrate 10 on a plane (X-Z plane in FIG. 2) including a direction in which the circuit unit 30a and the circuit unit 30b are arranged and a direction orthogonal to the front surface 20A is defined as an "observation cross section". In the observation cross section, the first bonding layer 52 may cover the entire second bonding layer 54, or the first bonding layer 52 may not cover a part of the second bonding layer 54. In each of five observation cross sections arbitrarily selected so as to have different positions in the Y-axis direction, a ratio of the second bonding layer 54 covering the first bonding layer 52 may be more than 50% or 60% or more.

The contents of various components constituting the first bonding layer 52 and the second bonding layer 54 are calculated by measuring the concentration in the vicinity of a bonding interface between the metal body and the ceramic plate using a scanning electron microscope and an energy dispersive X-ray spectroscopy (EDS) detector. In one example, a HAADF image regarding a cross section (cross section in the vicinity of the bonding interface) of the ceramic composite substrate 10 along the X-Z plane is acquired, and the contents of various components of the first bonding layer 52 and the second bonding layer 54 are measured by semiquantitative analysis using an EDS detector. When a carbon component derived from a measurement method or a detector is contained in a detection component, the content (mass%) of silver or the like is calculated after excluding the carbon component, assuming that the total of components other than the carbon component is 100 mass%. The content of various components is an arithmetic average of values measured at five observation cross sections arbitrarily selected so as to have different positions in the Y-axis direction. Furthermore, in one observation cross section, the content is measured on one line set along the Z-axis direction at an arbitrary position in the X-axis direction.

The bonding body 50 of the circuit unit 30a includes an extending portion (hereinafter, referred to as an "extending portion 58") protruding from between the metal body 40 and the front surface 20A toward the circuit unit 30b. In the extending portion 58, both the first bonding layer 52 and the second bonding layer 54 may protrude toward the circuit unit 30b. Depending on the position (cross-sectional position) in the Y-axis direction, only the second bonding layer 54 may protrude without the first bonding layer 52 protruding. The bonding body 50 may be formed such that a protrusion amount of the second bonding layer 54 is larger than a protrusion amount of the first bonding layer 52. The protrusion amount is defined by a distance in the X-axis direction between an end portion of the metal body 40 closest to the circuit unit 30b and an end portion of each bonding layer closest to the circuit unit 30b. In the cross section in which the first bonding layer 52 does not protrude, the protrusion amount of the first bonding layer 52 is 0. When ten observation cross sections arbitrarily selected so as to have different positions in the Y-axis direction are observed, a ratio of the cross section in which the first bonding layer 52 protrudes may be 60% or more.

The observation cross section is set at a position including both the circuit unit 30a and the circuit unit 30b in a direction (Y-axis direction in FIG. 2) orthogonal to the cross section. A distance between the circuit unit 30a and the circuit unit 30b in the observation cross section is set in consideration of insulation (electrical insulation properties) between metal bodies included in the circuit unit. The distance (the shortest distance in the X-axis direction) between the circuit unit 30a and the circuit unit 30b is, for example, 0.3 mm to 1.5 mm. In the observation cross section, a length of the extending portion 58 in the X-axis direction (the protrusion amount of the second bonding layer 54) may be 10 µm to 100 µm, and a thickness of the extending portion 58 (the sum of the thickness of the first bonding layer 52 and the thickness of the second bonding layer 54) may be 1 µm to 10 µm.

In the observation cross section, when a distance in the X-axis direction between the first bonding layer 52 and the circuit unit 30b is designated as "D1" and a distance in the X-axis direction between the second bonding layer 54 and the circuit unit 30b is designated as "D2", the distance D2 may be smaller than the distance D1. The distance D1 is the shortest distance in the X-axis direction between an end portion of the first bonding layer 52 closest to the circuit unit 30b and an end portion of the circuit unit 30b closest to the circuit unit 30a in the observation cross section. The distance D2 is the shortest distance in the X-axis direction between an end portion of the second bonding layer 54 closest to the circuit unit 30b and an end portion of the circuit unit 30b closest to the circuit unit 30a in the observation cross section. A difference (D1 - D2) between the distance D1 and the distance D2 may be more than 2 µm. The difference between the distance D1 and the distance D2 may be 3 µm or more, 4 µm or more, or 5 µm or more. The distance between the distance D1 and the distance D2 may be 25 µm or less.

Each value of the distance D1 and the distance D2 is a calculated average value of distances measured at five observation cross sections (five fields of view) arbitrarily selected so as to have different positions in the Y-axis direction. Each of the five locations is selected, for example, in each region when the circuit unit 30a is equally divided into five in the Y-axis direction. The distance D1 and the distance D2 may be measured at the same five observation cross sections. The length of the extending portion 58 in the X-axis direction and the thickness of the extending portion 58 described above are also arithmetic average values of measured values measured at five observation cross sections.

The metal coating 60 is a coating that covers the metal body 40. The metal coating 60 is formed, for example, for the purpose of adjusting a thermal expansion coefficient of the metal circuit board 30 (ceramic composite substrate 10) to improve the heat resistant cycle or to suppress the occurrence of rust (oxidation) of the metal body 40. The metal coating 60 may be formed by a plating method or a sputtering method. The metal coating 60 is, for example, metal plating formed by electroless plating.

The metal coating 60 covers the upper surface 42 and the lateral surface 44 of the metal body 40 when the front surface 20A is viewed from the Z-axis direction. The metal coating 60 covers the extending portion of the bonding body 50 in addition to the upper surface 42 and the lateral surface 44 of the metal body 40. In a state where the metal coating 60 covers the extending portion 58 of the bonding body 50, the metal coating 60 covers at least the upper surface of the extending portion 58 when the front surface 20A is viewed from the Z-axis direction. The metal coating 60 may be configured by a metal other than silver. The metal constituting the metal coating 60 may be different from the metal constituting the metal body 40. The material constituting the metal coating 60 is, for example, nickel, gold, a nickel alloy, or a gold alloy. The nickel alloy (alloy containing nickel as a main component) is, for example, a nickel-phosphorus alloy or a nickel-boron alloy.

In the example described above, the distance D2 is smaller than the distance D1, and in the extending portion 58, the second bonding layer 54 protrudes more outward than the first bonding layer 52. Therefore, the metal coating 60 is formed on the second bonding layer 54 in a portion where the upper surface of the second bonding layer 54 is exposed. Thereby, the metal coating 60 includes a portion (hereinafter, referred to as a "lateral portion 62") formed to cover the lateral surface (lateral side) of the first bonding layer 52 facing the circuit unit 30b. The lateral surface (lateral side) of the first bonding layer 52 facing the circuit unit 30b is a portion exposed when the circuit unit 30a is viewed from the circuit unit 30b along the X-axis direction, assuming that there is no metal coating 60.

The lateral portion 62 of the metal coating 60 overlaps a portion of the second bonding layer 54 protruding from the first bonding layer 52. When the circuit unit 30a is viewed in a direction from the circuit unit 30b toward the circuit unit 30a along the X-axis direction, the lateral portion 62 overlaps at least a part of the lateral surface of the first bonding layer 52 facing the circuit unit 30b. Depending on the position of the observation cross section, the lateral portion 62 may be in contact with the lateral surface of the first bonding layer 52, or a part of the metal body 40 may be present between the lateral portion 62 and the lateral surface of the first bonding layer 52.

In the observation cross section, when a distance (shortest distance) in the X-axis direction between an end portion of the lateral portion 62 close to the circuit unit 30b and an end portion of the first bonding layer 52 close to the circuit unit 30b is designated as "L" and a thickness of the metal coating 60 is designated as "H", the distance L is larger than the thickness H. The distance L may be 1.2 times or more the thickness H, 1.4 times or more the thickness H, or 1.6 times or more the thickness H. The distance L may be 5 times or less the thickness H.

Each of the value of the distance L and the value of the thickness H is measured similarly to the distances D1 and D2 described above. That is, each value of the distance L and the thickness H is a calculated average value of measured values measured at five observation cross sections (five fields of view) arbitrarily selected so as to have different positions in the Y-axis direction. The distance L and the thickness H may be measured at the same five observation cross sections. The measured value of the thickness H in one observation cross section is measured at a position near the center (the center and the vicinity thereof) in the thickness direction of the metal body 40 in a region covering the lateral surface 44 of the metal body 40.

The distance L (average value) may be more than 2 µm. The distance L may be 3 µm or more, 5 µm or more, or 7 µm or more. The distance L may be 20 µm or less. The thickness H (average value) may be 2 µm or more. The thickness H may be 3 µm or more, 4 µm or more, or 5 µm or more. The thickness H may be 10 µm or less.

The circuit unit 30b includes, similarly to the circuit unit 30a, the metal body 40, the bonding body 50, and the metal coating 60. The metal body 40, the bonding body 50, and the metal coating 60 of the circuit unit 30b may be formed in the same manner as the metal body 40, the bonding body 50, and the metal coating 60 of the circuit unit 30a. A distance in the X-axis direction between the second bonding layer 54 in the bonding body 50 of the circuit unit 30b and the circuit unit 30a may be smaller than a distance in the X-axis direction between the first bonding layer 52 in the bonding body 50 of the circuit unit 30b and the circuit unit 30a. Also on the back surface 20B, a metal circuit board configured in the same manner as in the metal circuit board 30 may be formed.

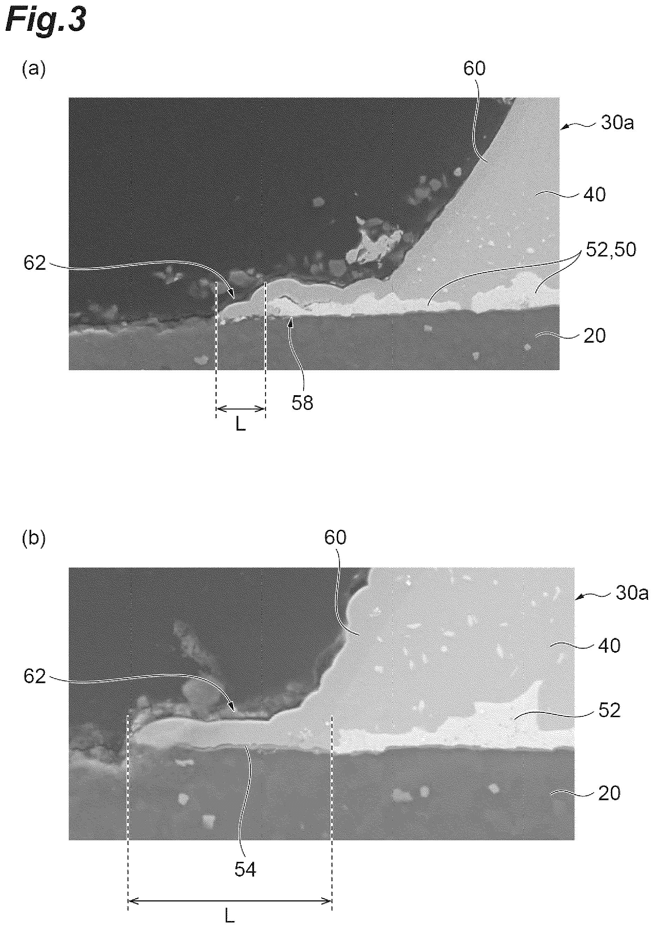

In each of FIG. 3(a) and FIG. 3(b), SEM images (magnification: 1000 times) obtained in arbitrarily selected observation cross sections. In the SEM image shown in FIG. 3(a), the lateral surface (lateral side) of the extending portion 58 is covered in a state of being in contact with the lateral portion 62 of the metal coating 60. In this case, the distance L corresponds to the length of the lateral portion 62 in the X-axis direction (lateral direction on the image). Furthermore, the first bonding layer 52 is discontinuously formed.

In the SEM image shown in FIG. 3(b), the first bonding layer 52 does not protrude from between the metal body 40 and the ceramic plate 20, and the second bonding layer 54 protrudes from between the metal body 40 and the ceramic plate 20. In the X-axis direction, a part of the metal body 40 is present between the lateral portion 62 and the first bonding layer 52. In this case, the distance L is larger than the length in the X-axis direction of the lateral portion 62.

### [Production Method for Ceramic Composite Substrate]

Subsequently, an example of a production method for a ceramic composite substrate will be described. The production method for a ceramic composite substrate includes a preparing step of a ceramic plate and a forming step of a metal circuit board. In the step of preparing the ceramic plate 20, first, a step of forming a slurry containing a ceramic powder, a sintering aid, a binder resin, and a solvent to obtain a green sheet is performed. The slurry may contain a plasticizer, a dispersant, and the like.

The ceramic powder is, for example, silicon nitride powder or aluminum nitride powder. Examples of the sintering aid include oxides, halides (such as fluorides and chloride), nitrates, and sulfates of rare earth elements, and oxides, halides (such as fluorides and chlorides), nitrates, and sulfates of alkaline earth metals. These may be used singly or in combination of two or more kinds thereof. Examples of the binder resin include methyl cellulose, ethyl cellulose, polyvinyl alcohol, polyvinyl butyral, and a (meth)acrylic resin.

Examples of the plasticizer include phthalic acid-based plasticizers such as purified glycerin, glycerin trioleate, diethylene glycol, and di-n-butyl phthalate, and dibasic acid-based plasticizers such as di-2-ethylhexyl sebacate. Examples of the dispersant include poly(meth)acrylate and (meth)acrylate-maleate copolymers. Examples of the solvent include organic solvents such as ethanol and toluene. Examples of the method for forming a slurry include a doctor blade method and an extrusion forming method.

Next, a step of degreasing and firing the green sheet obtained by molding is performed. The degreasing may be performed, for example, by heating at 400°C to 800°C for 0.5 hours to 20 hours. This makes it possible to reduce the residual amount of organic matter (carbon) while suppressing oxidation and deterioration of an inorganic compound. The firing is performed by heating to 1700°C to 1900°C in a non-oxidizing gas atmosphere such as nitrogen, argon, ammonia, or hydrogen. Thereby, the ceramic plate 20 can be obtained.

The degreasing and firing described above may be performed in a state where a plurality of green sheets are laminated. In the case of performing degreasing and firing after laminating, a release layer formed of a release agent may be provided between the green sheets in order to facilitate separation of a base material after firing. As the release agent, for example, boron nitride (BN) can be used. The number of green sheets to be laminated may be, for example, 5 to 100, and may be 10 to 70.

After the preparation of the ceramic plate 20, the forming step of a metal circuit board is performed. In the step of forming the metal circuit board 30, first, a step of obtaining an intermediate 18 using the ceramic plate 20 and a pair of metal plates is performed. Specifically, first, a bonding material (for example, a brazing material) is applied to each of the front surface 20A and the back surface 20B of the ceramic plate 20, and a pair of metal bodies 40M is pasted to the front surface 20A and the back surface 20B. The pair of metal bodies 40M may have a flat plate shape similar to that of the ceramic plate 20. The metal body 40M is a parent material of the metal body 40 described above.

The bonding material is applied to each of the front surface 20A and the back surface 20B of the ceramic plate 20 by a method such as a roll coater method, a screen printing method, or a transfer method. When the bonding material is a brazing material, the brazing material contains, for example, silver powder, copper powder, tin powder, powder of an active metal or a compound (hydride) thereof, an organic solvent, a binder, and the like. The content of the tin powder with respect to 100 parts by mass of the total of silver powder and copper powder may be 0.5 parts by mass to 5.0 parts by mass. The content of the metal hydride powder with respect to 100 parts by mass of the total of silver powder and copper powder may be 1 part by mass to 8 parts by mass. A viscosity of the brazing material may be, for example, 5 Pa s to 20 Pa s. A content of the organic solvent in the brazing material may be, for example, 5 mass% to 25 mass%, and a content of the binder may be, for example, 2 mass% to 15 mass%.

A laminate is obtained by superimposing the pair of metal bodies 40M on the front surface 20A and the back surface 20B of the ceramic plate 20 to which the bonding material is applied. Then, a firing step of firing the laminate in a heating furnace is performed. A furnace temperature (firing temperature) during firing is, for example, 750°C or higher. A firing temperature may be 750°C to 950°C, and may be 780°C to 900°C. A time for holding at the firing temperature (firing time) may be 10 minutes to 180 minutes, or may be 15 minutes to 90 minutes. The atmosphere in the heating furnace at the time of firing may be under an inert gas such as nitrogen, may be under reduced pressure of less than atmospheric pressure (1.0×10⁻³ Pa or less), or may be under vacuum.

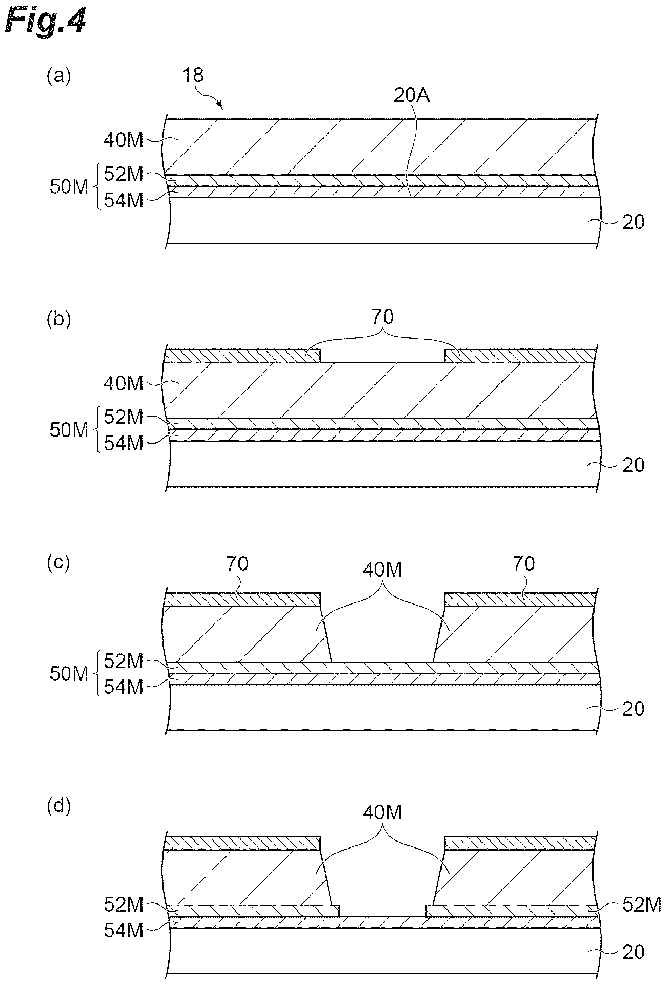

Through the above steps, the intermediate 18 in a state in which the metal body 40M is bonded to each of the front surface 20A and the back surface 20B of the ceramic plate 20 with a bonding body 50M interposed therebetween can be obtained. FIG. 4(a) schematically illustrates a cross section of the intermediate 18. By firing the laminate, the bonding material (bonding body 50M) is separated into a first bonding layer 52M and a second bonding layer 54M. The first bonding layer 52M (silver bonding layer) is a parent material of the first bonding layer 52 described above, and the second bonding layer 54M is a parent material of the second bonding layer 54 described above. In the drawings subsequent to FIG. 4(a), the metal circuit board (the metal plate and the bonding body) formed on the back surface 20B of the ceramic plate 20 is omitted.

Next, a step of masking a region where each circuit unit such as the circuit unit 30a is to be formed is performed. For example, as illustrated in FIG. 4(b), an etching resist 70 is printed in a region where each circuit unit such as the circuit unit 30a is to be formed. A part of the metal body 40M located in a region where the etching resist 70 is not formed is exposed.

Next, a step of etching a region of the metal body 40M that is not covered with the etching resist 70 is performed. For example, etching is performed on the metal body 40M using a mixed solution containing cupric chloride, hydrochloric acid, and hydrogen peroxide as an etching solution. Thereby, as illustrated in FIG. 4(c), the region of the metal body 40M that is not covered with the etching resist 70 is removed, and a part of the first bonding layer 52M of the bonding body 50M is exposed. In the metal body 40M separated after the removal, an inclined surface not covered with the etching resist 70 may be formed.

Next, a step of etching (chemical liquid treating) the first bonding layer 52M of the bonding body 50M. For example, etching is performed on the first bonding layer 52M using a chemical solution containing sodium thiosulfate as an etching solution. Thereby, as illustrated in FIG. 4(d), at least a part of the exposed portion of the first bonding layer 52M is removed, and a part of the second bonding layer 54M of the bonding body 50M is exposed. After the removal of the exposed portion of the first bonding layer 52M, an end portion of the first bonding layer 52M and the vicinity thereof may protrude outward from between the metal body 40M and the ceramic plate 20.

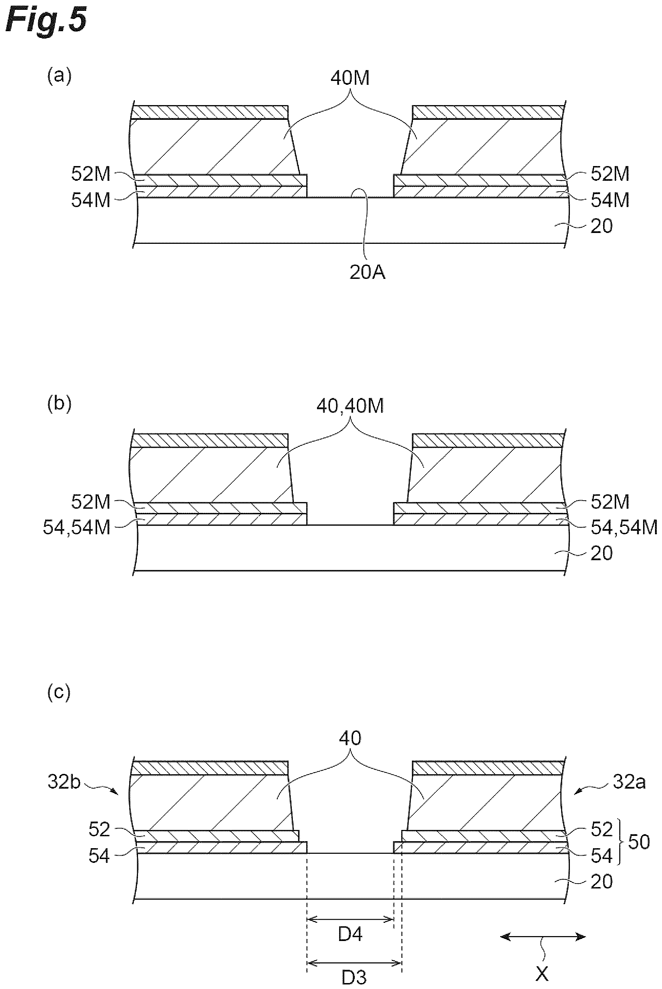

Next, a step of etching (chemical liquid treating) the second bonding layer 54M of the bonding body 50M. For example, etching is performed on the second bonding layer 54M using a mixed solution containing hydrogen peroxide and ammonium fluoride as an etching solution. Thereby, as illustrated in FIG. 5(a), at least a part of the exposed portion of the second bonding layer 54M is removed, and a part of the front surface 20A of the ceramic plate 20 is exposed. After the removal of the exposed portion of the second bonding layer 54M, an end portion of the second bonding layer 54M and the vicinity thereof may protrude outward from between the metal body 40M and the ceramic plate 20. A protrusion amount of the first bonding layer 52M and a protrusion amount of the second bonding layer 54M may be substantially coincide with each other.

Next, the step of etching the metal body 40M is performed again. In the second etching on the metal body 40M, the same mixed solution as in the first etching may be used, and an etching time on the metal body 40M in the second etching may be shorter than that in the first etching. Thereby, as illustrated in FIG. 5(b), a portion located on the lateral side of the metal body 40M is further removed, and the metal body 40 constituting the circuit unit such as the circuit unit 30a is formed. Furthermore, the protrusion amounts of the first bonding layer 52M and the second bonding layer 54M (second bonding layer 54) increase.

Next, the step of etching the first bonding layer 52M is performed again. In the second etching on the first bonding layer 52M, the same chemical solution as in the first etching may be used. Thereby, the first bonding layer 52 constituting the circuit unit such as the circuit unit 30a is formed. As illustrated in FIG. 5(c), the second etching may be performed on the first bonding layer 52M so that a state where at least a part of the end portion of the first bonding layer 52 protrudes from between the metal body 40 and the ceramic plate 20 is maintained. Since the second etching is not performed on the second bonding layer 54M, the second bonding layer 54 constituting the circuit unit such as the circuit unit 30a is formed by the etching on the second bonding layer 54M.

Here, a portion configured by the metal body 40 and the bonding body 50 after etching and before the metal coating 60 is formed is also referred to as a "circuit unit". A portion configured by the metal body 40 and the bonding body 50 corresponding to the circuit unit 30a is referred to as a "circuit unit 32a", and a portion configured by the metal body 40 and the bonding body 50 corresponding to the circuit unit 30b is referred to as a "circuit unit 32b". In the etching step described above, a part of the metal body 40M and a part of the bonding body 50M are etched so that the circuit unit 32a and the circuit unit 32b spaced apart from each other along the X-axis direction are formed. As in the etching step described above, a part of the metal body 40M and a part of the bonding body 50M may be removed such that a distance D4 in the X-axis direction between a part (second bonding layer 54) of the second bonding layer 54M constituting the circuit unit 32a and the circuit unit 32b is smaller than a distance D3 in the X-axis direction between a part (first bonding layer 52) of the first bonding layer 52M constituting the circuit unit 32a and the circuit unit 32b.

The distance D3 is defined by a distance in the X-axis direction between an end portion in the first bonding layer 52 of the circuit unit 32a (first circuit unit) closest to the circuit unit 32b (second circuit unit) and an end portion of the circuit unit 32b closest to the circuit unit 32a. The distance D4 is defined by a distance in the X-axis direction between an end portion in the second bonding layer 54 of the circuit unit 32a closest to the circuit unit 32b and an end portion of the circuit unit 32b closest to the circuit unit 32a. Note that the etching step on the metal body 40M and the bonding body 50M may be performed in any manner. After the etching step is performed on the metal body 40M and the bonding body 50M, the etching resist 70 is removed. The removal of the etching resist 70 may be performed by any known method.

Next, the step of forming the metal coating 60 so as to cover the surface of the metal body 40 (a part of the metal body 40M) is performed. For example, a plating film of metal such as nickel is formed by electroless plating so as to cover the upper surface 42 and the lateral surface 44 of the metal body 40. In the step of forming the metal coating 60, the metal coating 60 is formed so as to also cover the extending portion of the bonding body 50 protruding outward from between the metal body 40 and the ceramic plate 20. In the case of performing electroless plating, since the second bonding layer 54 protrudes more outward than the first bonding layer 52 in the extending portion, a metal component is deposited on the second bonding layer 54. Thereby, the lateral portion 62 covering the lateral side of the first bonding layer 52 is formed. No metal component is deposited on the exposed front surface 20A in electroless plating. Through the above steps, the ceramic composite substrate 10 illustrated in FIG. 1 and FIG. 2 is produced.

### [Effects of Embodiment]

The ceramic composite substrate 10 according to one aspect of the present disclosure includes: the ceramic plate 20; the circuit unit 30a provided on the front surface 20A of the ceramic plate 20; and the circuit unit 30b provided on the front surface 20A in a state of being spaced apart from the circuit unit 30a along the X-axis direction. The circuit unit 30a includes: the bonding body 50 provided on the front surface 20A; the metal body 40 bonded to the front surface 20A with the bonding body 50 interposed therebetween; and the metal coating 60 formed so as to cover the front surface 20A of the metal body 40 and a portion of the bonding body 50 protruding from the metal body 40. The bonding body 50 includes the first bonding layer 52 bonded to the metal body 40 and having a silver content of 50 mass% or more. The metal coating 60 includes the lateral portion 62 formed so as to cover a lateral surface of the first bonding layer 52, the lateral surface facing the circuit unit 30b. The distance L in the X-axis direction between an end portion of the lateral portion 62 close to the circuit unit 30b and an end portion of the first bonding layer 52 close to the circuit unit 30b is larger than the thickness H of the metal coating.

When a voltage is applied to a pair of circuit units arranged in a state of being separated from each other in a high temperature or high humidity environment, there is a concern that insulation properties may be deteriorated due to a silver component contained in the bonding body for bonding the metal body. As a factor of lowering the insulation properties, it is considered that a silver component is deposited between the pair of circuit units, and a resistance value between the pair of circuit units is lowered. On the other hand, in the ceramic composite substrate 10, since the distance L is larger than the thickness H of the metal coating 60, the metal coating is formed between the first bonding layer 52 of the circuit unit 30a and the circuit unit 30b in an amount sufficient to suppress deposition of a silver component. Therefore, insulation properties between the circuit unit 30a and the circuit unit 30b can be improved.

The distance L may be more than 2 µm. The thickness H may be 2 µm or more. In this case, a length in the X-axis direction of the lateral portion 62 formed between the first bonding layer 52 of the circuit unit 30a and the circuit unit 30b is more than 2 µm. Therefore, a metal film is formed on the lateral side of the first bonding layer 52 of the circuit unit 30a in such an amount that can further suppress deposition of a silver component from the first bonding layer 52. Therefore, insulation properties between the circuit unit 30a and the circuit unit 30b can be further improved.

The ceramic plate 20 may contain silicon nitride or aluminum nitride. The metal coating 60 may contain nickel or gold. Since the metal coating 60 containing nickel or gold is present on the lateral side of the first bonding layer 52, deposition of the silver component can be suppressed. Therefore, the above configuration is useful for maintaining insulation properties between the circuit unit 30a and the circuit unit 30b.

A production method for the ceramic composite substrate 10 according to one aspect of the present disclosure includes: a step of etching a part of the metal body 40M and a part of the bonding body 50M so as to form the circuit unit 32a and the circuit unit 32b in a state of being spaced apart from each other along the X-axis direction in the intermediate 18, in the intermediate 18 the metal body 40M being bonded to the front surface 20A of the ceramic plate 20 with the bonding body 50M interposed therebetween, the bonding body 50M including the first bonding layer 52M bonded to the metal body 40M and having a silver content of 50 mass% or more; and a step of forming the metal coating 60 so as to cover a surface of a part (metal body 40) of the metal body 40M constituting the circuit unit 32a and form the lateral portion 62 covering a lateral surface of a part (first bonding layer 52) of the first bonding layer 52M constituting the circuit unit 32a, the lateral surface facing the circuit unit 32b, after the step of etching. The distance L in the X-axis direction between an end portion of the lateral portion 62 included in the metal coating 60 close to the circuit unit 32b and an end portion of a part (first bonding layer 52) of the first bonding layer 52M constituting the circuit unit 32a close to the circuit unit 32b is larger than the thickness H of the metal coating 60. In this production method, since the distance L is larger than the thickness H of the metal coating 60, the metal coating is formed between the first bonding layer 52 of the circuit unit 32a and the circuit unit 32b in an amount sufficient to suppress deposition of a silver component. Therefore, insulation properties between the circuit unit 32a and the circuit unit 32b can be improved.

### Examples

Subsequently, the contents of the present disclosure will be described in more detail with reference to Example and Comparative Example; however, the present disclosure is not limited to the following Examples.

### (Example)

An Ag-Cu-Ti-Sn-based brazing material was prepared. A blending ratio of the prepared brazing material was 85 mass% of Ag, 9 mass% of Cu, 3 mass% of Ti, and 3 mass% of Sn. The brazing material was applied to both main surfaces of a commercially available silicon nitride substrate (thickness: 0.32 mm) by a screen printing method. A copper plate (thickness: 0.3 mm) was overlaid on each of both the main surfaces of the silicon nitride plate to obtain a laminate. The laminate was heated at a furnace temperature of 800°C for 40 minutes in a vacuum atmosphere using an electric furnace to melt the brazing material powder, thereby bonding the ceramic plate and the copper plate (firing step). Then, the temperature in the furnace was cooled to 600°C at a temperature decreasing rate of 10°C/min on average. Thereafter, the heating was stopped, and the mixture was naturally cooled to room temperature in a nitrogen atmosphere. In this way, an intermediate was prepared in which the ceramic plate and the pair of metal plates were bonded to each other with the bonding body obtained from the brazing material interposed therebetween.

Next, an etching resist was printed on predetermined regions of both main surfaces of the copper plate in the prepared intermediate, and a resist pattern having a predetermined shape was formed on the main surface of the copper plate using an exposure apparatus. Then, the copper plate was etched using a mixed solution containing cupric chloride, hydrochloric acid, and hydrogen peroxide. Thereafter, etching of the first bonding layer containing silver as a main component of the bonding body was performed using a chemical solution containing sodium thiosulfate. Further, etching of the second bonding layer was performed using a mixed solution containing hydrogen peroxide and ammonium fluoride. In the etching of the copper plate and the bonding body, the number of times of execution of various steps and the conditions in each etching were adjusted so that the second bonding layer protruded more outward than the first bonding layer. Next, a plating film of nickel (Ni) was formed by electroless plating so that the distance L became larger than the thickness H and covered the surface of the metal body and a portion of the bonding body protruding from the metal body. By repeating at least a part of the above steps, five individuals were prepared as the ceramic composite substrate 10 according to Example.

### (Comparative Example)

A ceramic composite substrate was prepared in the same manner as in the above Examples, except that a nickel plating film was not formed. Five individuals were prepared as ceramic composite substrates according to Comparative Example. Note that, as composite substrates according to Example and Comparative Example, ceramic composite substrates with comb-shaped electrodes in which a first electrode including a first circuit unit and a second electrode including a second circuit unit were formed, were prepared.

The insulation properties between the first circuit unit and the second circuit unit adjacent to the first circuit unit were evaluated. In both of Example and Comparative Example, the distance between the first circuit unit and the second circuit unit was 0.5 mm. In a high temperature and high humidity bath, a voltage of DC (direct current) 1 kV was continuously applied between the first electrode including the first circuit unit and the second electrode including the second circuit unit under an atmosphere of 85°C and 93% RH, and the time during which the insulation resistance value between the first electrode and the second electrode became 1×10⁶ Ω or less was measured. The upper limit of the measurement time was set to 500 hours. The results of evaluating the five individuals are shown in Table 1. Note that the thickness H was 4 µm, the distance L was 8 µm, and the difference between the distance D1 and the distance D2 was 8 µm. Furthermore, the silver content in the first bonding layer 52 was 90 mass%.

**[Table 1]**

| Evaluation determination | Example | Comparative Example |
|---|---|---|
| A | 5 | 0 |
| B | 0 | 1 |
| C | 0 | 4 |

In Table 1, the meanings of "A", "B", and "C" are as follows. This indicates that the insulation properties are maintained in the order of A determination, B determination, and C determination.
A: The insulation resistance value was maintained at a value larger than 1×10⁶ Ω even after exceeding 500 hours from the voltage application start time.
B: The insulation resistance value decreased to 1×10⁶ Ω or less during 100 hours to 500 hours from the voltage application start time.
C: The insulation resistance value decreased to 1×10⁶ Ω or less within less than 100 hours from the voltage application start time.

As shown in Table 1, in the five composite substrates for evaluation in Example, the evaluation of the insulation properties was A determination for all composite substrates. In the five composite substrates for evaluation in Comparative Example, the evaluation of the insulation properties on one composite substrate was B determination, and the evaluation of the insulation properties on four composite substrates was C determination. From the above evaluation results, it is found that the insulation properties are improved by forming the metal coating such that the distance L is larger than the thickness H.

### Reference Signs List

10 ceramic composite substrate
20 ceramic plate
30 metal circuit board
30a, 30b, 30c circuit unit
40 metal body
50 bonding body
52 first bonding layer
54 second bonding layer
60 metal coating
62 lateral portion
18 intermediate
32a, 32b circuit unit
40M metal body
50M bonding body
52M first bonding layer
54M second bonding layer.

## Claims

1. A ceramic composite substrate comprising:
a ceramic plate;
a first circuit unit provided on a main surface of the ceramic plate; and
a second circuit unit provided on the main surface in a state of being spaced apart from the first circuit unit along a predetermined direction, wherein
the first circuit unit includes:
a bonding body provided on the main surface;
a metal body bonded to the main surface with the bonding body interposed therebetween; and
a metal coating formed so as to cover a surface of the metal body and a portion of the bonding body protruding from the metal body,
the bonding body includes a silver bonding layer bonded to the metal body and having a silver content of 50 mass% or more,
the metal coating includes a lateral portion formed so as to cover a lateral surface of the silver bonding layer, the lateral surface facing the second circuit unit, and
a distance L in the predetermined direction between an end portion of the lateral portion close to the second circuit unit and an end portion of the silver bonding layer close to the second circuit unit is larger than a thickness H of the metal coating.

2. The ceramic composite substrate according to claim 1, wherein
the distance L is more than 2 µm, and
the thickness H is 2 µm or more.

3. The ceramic composite substrate according to claim 1 or 2, wherein
the ceramic plate contains silicon nitride or aluminum nitride, and
the metal coating contains nickel or gold.

4. A production method for a ceramic composite substrate, the production method comprising:
a step of etching a part of a metal body and a part of a bonding body so as to form a first circuit unit and a second circuit unit in a state of being spaced apart from each other along a predetermined direction in an intermediate, in the intermediate the metal body being bonded to a main surface of a ceramic plate with the bonding body interposed therebetween, the bonding body including a silver bonding layer bonded to the metal body and having a silver content of 50 mass% or more; and
a step of forming a metal coating so as to cover a surface of a part of the metal body constituting the first circuit unit and form a lateral portion covering a lateral surface of a part of the silver bonding layer constituting the first circuit unit, the lateral surface facing the second circuit unit, after the step of etching, wherein
a distance L in the predetermined direction between an end portion close to the second circuit unit of the lateral portion included in the metal coating and an end portion close to the second circuit unit of a part of the silver bonding layer constituting the first circuit unit is larger than a thickness H of the metal coating.
